# EUROPEAN PATENT APPLICATION

(11) **EP 4 773 495 A1**
(43) Date of publication of application: **08.07.2026**
(21) Application number: 24909413.7
(22) Date of filing: 08.03.2024
(51) Int. Cl.: H02M 3/07

(54) **DRIVING POWER SUPPLY, DRIVING METHOD AND SYSTEM FOR CENTRAL SOLENOID, AND FUSION REACTION SYSTEM**

(30) Priority: 27.12.2023 CN 202311827556
(71) Applicant: Shanghai Startorus Fusion Technology Company Limited, Shanghai 201808 (CN)
(72) Inventor: ZHANG, Haitao, Xi'an, Shaanxi 712000 (CN); SONG, Zichong, Xi'an, Shaanxi 712000 (CN); ZHOU, Hongran, Xi'an, Shaanxi 712000 (CN); CHEN, Rui, Xi'an, Shaanxi 712000 (CN); TAN, Yi, Xi'an, Shaanxi 712000 (CN)
(74) Representative: Valet Patent Services Limited
(86) International application number: PCT/CN2024/080756
(87) International publication number: WO 2025/138442

(57) **Abstract**

The present application provides a driving power supply, driving method and system for a central solenoid, and a fusion reaction system. In each of power supply modules of the driving power supply, a positive electrode of a capacitor unit is connected to a first end of a first power unit, a second end of the first power unit and a first end of a second power unit are connected to an auxiliary node, and a second end of the second power unit is connected to a negative electrode of the capacitor unit; the second end of the second power unit in any power supply module is connected to the second end of the second power unit in another power supply module set; the auxiliary node in one power supply module set is connected to a current limiting resistor, a third power unit and an output end of an auxiliary diode, the other end of the current limiting resistor, the other end of the third power unit and an input end of the auxiliary diode are connected to one end of the central solenoid, and the auxiliary node in another power supply module set is connected to the other end of the central solenoid; the power units are controlled, so that the capacitor unit that transmits current is switched between different power supply module sets.

## Description

### CROSS-REFERENCE TO RELATED APPLICATIONS

The present application claims the priority of the Chinese patent application No.202311827556.3 filed to the China Patent Office on December 27, 2023, and entitled "DRIVING POWER SUPPLY, DRIVING METHOD AND SYSTEM OF CENTER SOLENOID, AND FUSION REACTION SYSTEM", of which the entire contents are incorporated herein by reference.

### TECHNICAL FIELD

The present application relates to the technical field of power electronics, and in particular, to a driving power supply, a driving method and system of a center solenoid, and a fusion reaction system.

### BACKGROUND

With the development of electronic technology, there are more and more electronic devices with various functions, and the electronic devices with different functions have different requirements for current. For example, a nuclear fusion reaction apparatus needs to transmit pulse current with a relatively high change rate to a center solenoid to cause a rapid change of a surrounding electromagnetic field, so as to ionize and breakdown around this coil to form an initial plasma ring. A plasma in the initial plasma ring may then be heated to a fusion reaction temperature, so as to generate a fusion reaction. However, a change rate of the current transmitted currently to the center solenoid is relatively low at present, which is difficult to meet the requirements of the nuclear fusion reaction apparatus, so a power supply is urgently needed to transmit pulse current with a relatively high change rate to the center solenoid.

### SUMMARY

In view of this, the present application provides a driving power supply, a driving method and system of a center solenoid, and a fusion reaction system, which may transmit pulse current with a relatively high change rate to the center solenoid to meet the requirements of a nuclear fusion reaction.

According to one aspect of the present application, a driving power supply is provided, including: two power supply module sets; where each power supply module set includes at least one power supply module; each power supply module includes a capacitor unit, a first power unit and a second power unit; a positive electrode of the capacitor unit is connected with a first end of the first power unit, a second end of the first power unit and a first end of the second power unit are connected with an auxiliary node, and a second end of the second power unit is connected with a negative electrode of the capacitor unit; and a second end of a second power unit in any power supply module of any power supply module set is connected with a second end of a second power unit in a power supply module of the other power supply module set; a current-limiting resistor, a third power unit and an auxiliary diode; where in the two power supply module sets, an auxiliary node in one power supply module set is connected with a first end of the current-limiting resistor, a first end of the third power unit and an output end of the auxiliary diode; a second end of the current-limiting resistor, a second end of the third power unit and an input end of the auxiliary diode are connected with one end of a center solenoid, and an auxiliary node in the other power supply module set is connected with the other end of the center solenoid; and each power unit is controlled to be turned on or turned off, so that a capacitor unit for transmitting current to the center solenoid is switched between a capacitor unit in a first power supply module and a capacitor unit in a second power supply module; where the first power supply module and the second power supply module belong to different power supply module sets, respectively.

According to another aspect of the present application, a driving system of a center solenoid is provided, including: an upper computer, a serial server, a driving unit of a power unit and the above driving power supply; where the upper computer is connected with the serial server, the upper computer is configured to send a control instruction to the driving unit of the power unit via the serial server; and the driving unit of the power unit is configured to control the power unit in the driving power supply to be turned on or turned off based on the received control instruction. According to yet another aspect of the present application, a driving method of a center solenoid is provided. The method is applied to the above driving power supply, and includes: turning on a first power unit group and a third power unit in the driving power supply, so that a capacitor unit in a first power supply module in the driving power supply supplies power to the center solenoid; where the first power unit group includes a first power unit in the first power supply module and a second power unit in a second power supply module; turning off the first power unit group and the third power unit in a case where current transmitted in the center solenoid reaches a first current value, so that the capacitor unit in the first power supply module stops supplying power to the center solenoid; turning on a second power unit group and the third power unit in the driving power supply, so that a capacitor unit in the second power supply module supplies power to the center solenoid, and a direction of the current on the center solenoid is reversed; where the second power unit group includes a first power unit in the second power supply module and a second power unit in the first power supply module; and turning off the second power unit group and the third power unit in a case where the current transmitted in the center solenoid reaches a second current value, so that the capacitor unit in the second power supply module stops supplying power to the center solenoid.

According to further another aspect of the present application, a fusion reaction system is provided, and the fusion reaction system includes: a nuclear fusion reaction apparatus and the above driving system; a driving power supply in the driving system is connected with a center solenoid in the nuclear fusion reaction apparatus and is configured to transmit pulse current to the center solenoid; and the center solenoid is configured to generate a magnetic field based on the pulse current and generate an initial plasma ring by using the magnetic field, and a plasma in the initial plasma ring is configured to be heated to a fusion reaction temperature to generate a fusion reaction.

The driving power supply provided in the present application includes two power supply module sets which are respectively connected with the two ends of the center solenoid, the power supply module in each power supply module set includes the capacitor unit, the first power unit and the second power unit which are sequentially connected, and the auxiliary node between these two power units is connected with the center solenoid. The second end of each second power unit in any power supply module set is connected with the second end of one second power unit in the other power supply module set. This driving power supply can be turned on or turned off via each power unit, so that the capacitor unit for transmitting the current to the center solenoid is switched among the capacitor units in different power supply module sets. A switching of the capacitor unit can reverse the direction of the current transmitted on the center solenoid, so that positive and negative pulse current can be transmitted to the center solenoid alternately, and a relatively high change rate of the current transmitted to the center solenoid is ensured.

### BRIEF DESCRIPTION OF THE DRAWINGS

FIG. 1 is a schematic structural diagram of a circuit of a driving power supply of a center solenoid provided in an embodiment of the present application;
FIG. 2 is a schematic structural diagram of a circuit of another driving power supply of a center solenoid provided in an embodiment of the present application;
FIG. 3 is a schematic structural diagram of a circuit of yet another driving power supply of a center solenoid provided in an embodiment of the present application;
FIG. 4 is a schematic structural diagram of a circuit of further another driving power supply of a center solenoid provided in an embodiment of the present application;
FIG. 5 is a schematic diagram of a current change on a center solenoid provided in an embodiment of the present application;
FIG. 6 is a schematic structural diagram of a control system provided in an embodiment of the present application;
FIG. 7 is a flow chart of a driving method of a center solenoid provided in an embodiment of the present application;
FIG. 8 is a flow chart of another driving method of a center solenoid provided in an embodiment of the present application; and
FIG. 9 is a simple working flow chart of a driving system of a center solenoid provided in an embodiment of the present application.

### DETAILED DESCRIPTION

In the following description, numerous specific details are set forth in order to provide a thorough understanding of the present application. However, the present application is capable of being implemented in many other ways than those described herein, and those skilled in the art may make similar promotions without violating the meaning of the present application, and therefore the present application is not limited by the specific implementation disclosed below.

Terms used in one or more embodiments of the present application are intended only to describe specific embodiments and are not intended to limit one or more embodiments of the present application. The terms "a", "the" and "this" in the singular form as used in one or more embodiments of the present application and the accompanying claims are also intended to include the majority form unless the context clearly indicates otherwise. It should also be understood that the term "and/or" as used in one or more embodiments of the present application refers to and encompasses any or all possible combinations of one or more associated listed items. The term "at least one" in one or more embodiments of the present application means "one or more", and "more" means "two or more". The term "include/comprise" is an open-ended description and should be understood to mean "including/comprising but not limited" and may further include additional content in addition to what has been described.

It should be understood that although the terms "first", "second" and the like may be used to describe various information in one or more embodiments of the present application, such information should not be limited to these terms. These terms are used only to distinguish the same type of information from one another. For example, without departing from the scope of one or more embodiments of the present application, "first" may also be referred to as "second", and similarly, "second" may also be referred to as "first". Depending on the context, the word "if" as used here may be interpreted as "when..." or "while..." or "in response to determining".

In the field of electronic technology, all kinds of electronic devices require a power supply apparatus to supply power, and the power supplies required by different electronic devices are different. The power supply required for a nuclear fusion reaction apparatus is different from that required for an ordinary electronic device. Exemplarily, a spherical tokamak (ST) apparatus is a nuclear fusion reaction apparatus. The ST apparatus includes a vertically stacked center solenoid (CS) coil. The CS coil needs to transmit a strong current pulse, which causes a rapid change of a surrounding electromagnetic field to generate a strong electric field, so that gas surrounding this coil is ionized and broken down to form an initial plasma ring. A plasma in the initial plasma ring is then heated to a fusion reaction temperature so as to realize a nuclear fusion reaction. The CS coil plays a key role in an induced generation of plasma current, and shaping and stabilization of a plasma in the ST apparatus. In order to achieve a stable strong electric field generated by the CS coil to produce the plasma, it is necessary to have a relatively high change rate (di/dt) of current transmitted to the CS coil and to form a periodic positive and negative current pulse in a short period of time. However, a change rate of output current of the current power supply is still relatively low, which is difficult to meet the requirement.

The following embodiments of the present application provide a driving power supply of a center solenoid, which can provide current with a periodic positive and negative pulse for the center solenoid of a nuclear fusion reaction apparatus, and the current has a relatively high change rate, so that the center solenoid can generate a required strong electric field, thereby ensuring a generation effect of a plasma. The center solenoid described in the embodiments of the present application refers to a center solenoid coil. The embodiment of the present application further relates to a driving method and a driving system of a center solenoid, and a fusion reaction system.

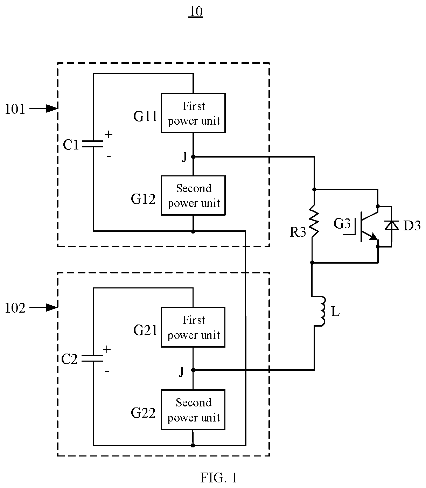

FIG. 1 is a schematic structural diagram of a circuit of a driving power supply of a center solenoid provided in an embodiment of the present application. As shown in FIG. 1, this driving power supply 10 includes two power supply module sets, for example, these two power supply module sets include a first power supply module set 101 and a second power supply module set 102. These two power supply module sets are configured to be connected with two ends of a load, respectively. The load in the embodiment of the present application is a center solenoid L in a nuclear fusion reaction apparatus. The following takes that the first power supply module set 101 is connected with a first end of the center solenoid L, and the second power supply module set 102 is connected with a second end of the center solenoid L as an example for illustration.

In the embodiment of the present application, the above driving power supply 10 further includes: a current-limiting resistor R3, a third power unit G3, and an auxiliary diode D3. This current-limiting resistor R3 may be connected in series with the center solenoid L, this third power unit G3 is connected in parallel with the current-limiting resistor R3, and this auxiliary diode D3 is connected in parallel with this third power unit G3. For example, a first end of the current-limiting resistor R3, a first end of the third power unit G3 and an output end of the auxiliary diode D3 are connected, and a second end of the current-limiting resistor R3, a second end of the third power unit G3 and an input end of the auxiliary diode D3 are connected. A structure composed of the current-limiting resistor R3, the third power unit G3, and the auxiliary diode D3 may be referred to as a switch resistor. As shown in FIG. 1, the first power supply module set 101 is connected with the first end of the center solenoid L via a switch resistor.

In the embodiment of the present application, each power supply module set of the above two power supply module sets includes at least one power supply module. In FIG. 1, only one power supply module is shown in each power supply module set. Each power supply module in these two power supply module sets may include a capacitor unit, a first power unit, and a second power unit. In each power supply module, a positive electrode of the capacitor unit is connected with a first end of the first power unit; a second end of the first power unit and a first end of the second power unit are connected and are connected with an auxiliary node J, and this auxiliary node J is located between the first power unit and the second power unit; and a second end of the second power unit is connected with a negative electrode of the capacitor unit.

In the embodiment of the present application, a capacitor unit included in the power supply module in the first power supply module set 101 is referred to as a first capacitor unit C1, and a capacitor unit included in the power supply module in the second power supply module set 102 is referred to as a second capacitor unit C2. In the first power supply module set 101, a first power unit included in the power supply module is represented by a power unit G11, and a second power unit is represented by a power unit G12. In the second power supply module set, a first power unit included in the power supply module is represented by a power unit G21, and a second power unit is represented by a power unit G22.

In the above two power supply module sets, a second end of a second power unit in any power supply module of any power supply module set is connected with a second end of a second power unit in one power supply module of the other power supply module set. As shown in FIG. 1, each of these two power supply module sets includes one power supply module, and the second ends of the two second power units in these two power supply modules are connected. For the convenience of description, the connection of the second ends of the two second power units is simply referred to as the connection of two second power units.

In some implementations, a certain power supply module set may include a plurality of power supply modules. In this case, it is only necessary to ensure that each second power unit is connected with one second power unit in the other power supply module set, and the embodiment of the present application does not limit a specific connection between the second power units G2 of various power supply module. For example, each second power unit may be connected with only one second power unit, or one second power unit may be connected with a plurality of second power units in the other power supply module set.

The auxiliary nodes J in the above two power supply module sets are configured to be connected with two ends of the center solenoid L, respectively, that is, each power supply module set uses the auxiliary node J in each power supply module to connect one end of this power supply module set that needs to be connected in the center solenoid L. For example, in FIG. 1, the auxiliary node J in the first power supply module set 101 is connected with the first end of the center solenoid L via a switch resistor, and the auxiliary node J in the second power supply module set 102 is connected with the second end of the center solenoid L. Specifically, the auxiliary node J in the first power supply module set 101 is connected with the first end of the current-limiting resistor R3, the first end of the third power unit G3, and the output end of the auxiliary diode D3, and the second end of the current-limiting resistor R3, the second end of the third power unit G3, and the input end of the auxiliary diode D3 are connected with the first end of the center solenoid L. If the first power supply module set 101 includes a plurality of power supply modules, the auxiliary node J between two power units in each power supply module in this plurality of power supply modules is connected with the first end of the center solenoid L via the switch resistor. Similarly, for the second power supply module set 102, the auxiliary node J in each power supply module is connected with the second end of the center solenoid L. In the above driving power supply 10, each power unit (including the first power unit, the second power unit, and the third power unit in the power supply module) may be controlled to be turned on or turned off, so that a capacitor unit for transmitting current to the center solenoid L is switched between a capacitor unit in the first power supply module and a capacitor unit in the second power supply module. The first power supply module and the second power supply module belong to different power supply module sets, respectively. The first power supply module and the second power supply module referred in the embodiment of the present application are only configured to distinguish that they belong to different power supply module sets, the first power supply module and the second power supply module can be replaced with each other, a control method for the first power supply module and the second power supply module can be the same, and the introductions to the first power supply module and the second power supply module can be referred to each other. For example, the first power supply module is a power supply module in the first power supply module set 101, and the second power supply module is a power supply module in the second power supply module set 102. Therefore, the capacitor unit for transmitting the current to the center solenoid L is switched between the first capacitor unit C1 and the second capacitor unit C2. With the switching of the capacitor unit for power supply, a direction of the current on the center solenoid L may change, and the center solenoid L may alternately transmit positive current and negative current, which is equivalent to transmitting a positive and negative current pulse with a relatively large current change rate.

In a target phase in which the current is transmitted to the center solenoid via the capacitor unit of the first power supply module, the first power unit in the first power supply module may be controlled to be turned on and the second power unit in the first power supply module may be controlled to be turned off, and the first power unit in the second power supply module is controlled to be turned off and the second power unit in the second power supply module is controlled to be turned on. The first power supply module and the second power supply module are interchanged to obtain a control method of the power unit in the target phase in which the capacitor unit of the second power supply module transmits the current to the center solenoid, which will not be repeated herein.

Exemplarily, for the power supply module set shown in FIG. 1, the power unit G11 and the power unit G22 may be controlled to be turned on, and the power unit G12 and the power unit G21 may be controlled to be turned off. In this way, the first capacitor unit C1, the power unit G11, the power unit G22 and the center solenoid L form a current loop, and the first capacitor unit C1 transmits the current to the center solenoid L. For another example, the power unit G12 and the power unit G21 may be controlled to be turned on, and the power unit G11 and the power unit G22 may be controlled to be turned off. In this way, the second capacitor unit C2, the power unit G21, the power unit G12 and the center solenoid L form the current loop, and the second capacitor unit C2 transmits the current to the center solenoid L.

In the embodiment of the present application, it first makes the first capacitor unit C1 to supply power to the center solenoid L, and then switches to making the second capacitor unit C2 to supply power to the center solenoid L . In this case, the center solenoid L transmits positive current first, and then switches to transmitting negative current. Alternatively, it first makes the second capacitor unit C2 to supply power to the center solenoid L first, and then switches to making the first capacitor unit C1 to supply power to the center solenoid L. In this case, the center solenoid L transmits the negative current first, and then switches to transmitting the positive current.

After the first capacitor unit C1 and the second capacitor unit C2 alternately transmit the current to the center solenoid L for one power supply cycle, the first capacitor unit C1 and the second capacitor unit C2 may be charged, and after the charging is completed, the current is transmitted to the center solenoid L again. In some implementations, if a capacitance of the capacitor unit is relatively large, the first capacitor unit C1 and the second capacitor unit C2 may alternately transmit the current to the center solenoid L for a plurality of power supply cycles before charging. The capacitor unit can be obtained by connecting a plurality of sub-capacitors in parallel. In the embodiment of the present application, one power supply cycle includes a process in which the first capacitor unit C1 and the second capacitor unit C2 respectively supply power to the center solenoid L once.

In the embodiment of the present application, whether the current-limiting resistor R3 functions in the circuit may be controlled by controlling the turning on or turning off of the third power unit G3. The current-limiting resistor R3 can limit the current in a freewheeling phase of the center solenoid L.

The third power unit G3 can be maintained to be turned on during a process that the capacitor unit supplies power to the center solenoid L. In this way, it can be ensured that the current does not flow through the current-limiting resistor R3 in this process, but flows through the third power unit G3 to be transmitted to the center solenoid L, thereby avoiding a waste of electric energy and ensuring that the current on the center solenoid L quickly reaches a required value. Exemplarily, the third power unit G3 is maintained to be turned on when the power units G11 and G22 are turned on, and the third power unit G3 is also maintained to be turned on when the power units G12 and G21 are turned on.

In an implementation, the third power unit G3 may be turned on first, and then the power units G11 and G22 (or the power units G12 and G21) may be turned on, so that the current transmitted by the capacitor unit is prevented from passing through the current-limiting resistor R3, thereby ensuring a relatively high efficiency of supplying power to the center solenoid L. In one embodiment, the third power unit G3 and the power units G11 and G22 may be turned on simultaneously, or the power units G11 and G22 may be turned on first. The power units G11 and G22 may not be turned on at the same time.

The third power unit G3 can be maintained to be turned off during the process that there is no need for the capacitor unit to supply power to the center solenoid L. In this way, the current can be ensured to flow through the current-limiting resistor R3 in a freewheeling process of the center solenoid L, so that a current reduction rate in the circuit is increased, and the current change rate is improved. Exemplarily, the third power unit G3 may be turned off simultaneously when the power units G11 and G22 (or the power unit G12 and G21) are turned off.

By adopting the above switch resistor in the driving power supply 10 of the embodiment of the present application, the driving power supply 10 can have a higher current change capability without increasing the power of the power supply, so that the ionization and breakdown of gas can be realized more easily, and a steady-state value of the plasma current can be significantly increased.

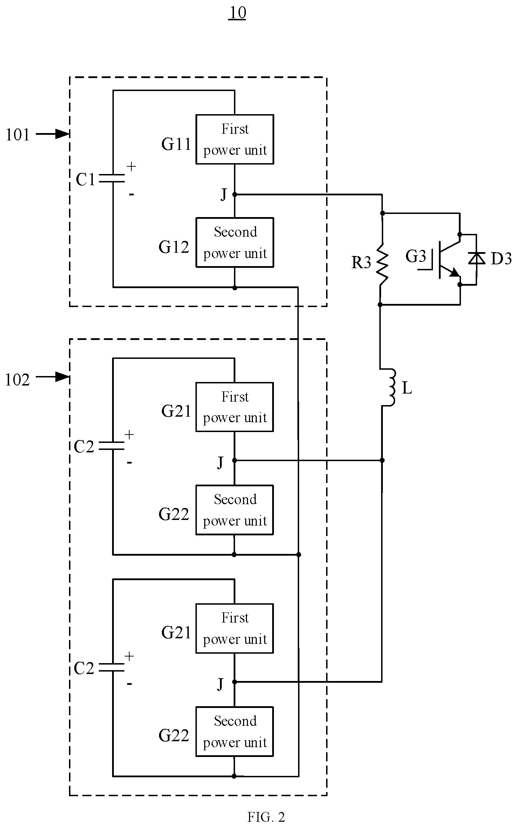

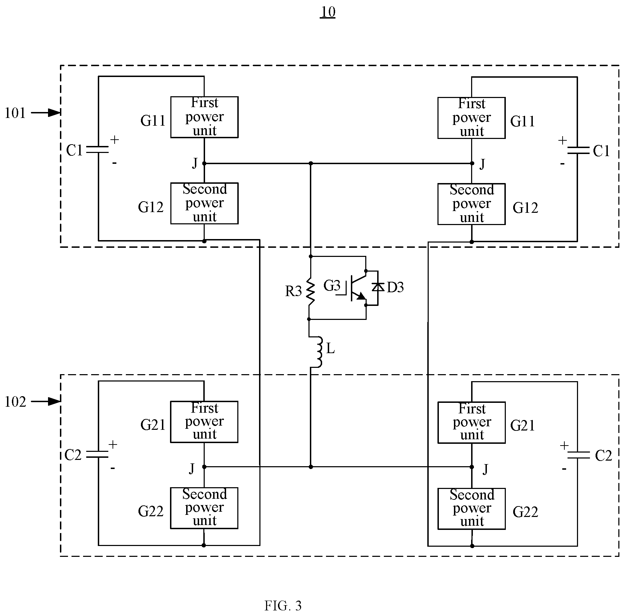

A case where the power supply module set in the driving power supply 10 includes a plurality of power supply modules is illustrated below in combination with FIG. 2 and FIG. 3. FIG. 2 is a schematic structural diagram of a circuit of another driving power supply of a center solenoid provided in an embodiment of the present application, and FIG. 2 illustrates that the second power supply module set 102 includes two power supply modules. As shown in FIG. 2, the auxiliary nodes J of these two power supply modules in the second power supply module set 102 are connected with the second end of the center solenoid L, and the second ends of the two second power units G22 in the above two power supply modules are connected with the second end of the second power unit G12 in the first power supply module set 101.

The capacitor unit supplying power to the center solenoid L can be switched between the first capacitor unit C1 and any one of the second capacitor units C2 in the second power supply module set 102. For example, the capacitor unit supplying power to the center solenoid L in two power supply cycles can be respectively switched from the first capacitor unit C1 to two different second capacitor units C2 in the second power supply module set 102. In one power supply cycle, in a process that the first capacitor unit C1 supplies power to the center solenoid L, the second power unit G22 through which the current flows may belong to a same power supply module as the second capacitor unit C2 used in this power supply cycle, or may be a second power unit G22 in other power supply modules in the second power supply module set 102.

In the embodiment of the present application, only a case where the second power supply module set 102 includes a plurality of power supply modules is introduced by way of example. A case where the first power supply module set 101 includes a plurality of power supply modules can be analogized, and is not repeated herein. For a case that both the first power supply module set 101 and the second power supply module set 102 include a plurality of power supply modules, each second power unit may be connected with a plurality of other second power units. For example, each second power unit in the first power supply module set 101 is connected with each second power unit in the second power supply module set 102, and this manner may also be analogized based on the introduction of FIG. 2; or each second power unit may only be connected with one other second power unit, and this manner is introduced below in combination with FIG. 3.

FIG. 3 is a schematic structural diagram of a circuit of yet another driving power supply of a center solenoid provided in an embodiment of the present application, and FIG. 3 takes that both the first power supply module set 101 and the second power supply module set 102 include two power supply modules as an example for illustration. As shown in FIG. 3, the number of the second power units in the first power supply module set 101 is the same as that in the second power supply module set 102, and each second power unit in the first power supply module set 101 is connected with each second power unit in the power supply module set 102 in a one-to-one correspondence manner.

Exemplarily, the two power supply modules respectively belonging to the first power supply module set 101 and the second power supply module set 102 constitute one power supply module pair, and the second ends of the two second power units in one power supply module pair are connected. The two capacitor units in one power supply module pair can be switched to supplying power to the center solenoid L in one power supply cycle. For example, the above first power supply module and the second power supply module form one power supply module pair. Different power supply module pairs can be replaced with each other, for example, after an electric quantity of the capacitor unit in one power supply module pair is lower than a specified value, the power units in this power supply module pair can be turned off, and the capacitor units in other power supply modules are replaced to supply power to the center solenoid L. In this way, it is possible to continuously supply power to the center solenoid L for a plurality of cycles.

The two power supply modules in FIG. 1 also constitute one power supply module pair. Based on the driving power supply 10 shown in FIG. 1, at least one power supply module pair having a same structure and connection relationship as the two power supply modules shown in FIG. 1 may be added, so as to obtain the driving power supply 10 (as the driving power supply 10 shown in FIG. 3) in which each power supply module set includes a plurality of power supply modules.

In the embodiment of the present application, by switching the first capacitor unit C1 and the second capacitor unit C2 to transmit the current to the center solenoid L, it is possible to generate the positive and negative current pulse multiple times in a short time. When a positive current transmitted from the first capacitor unit C1 to the center solenoid L reaches a predetermined value and then suddenly decreases, a strong electric field is generated around the center solenoid L, thereby generating plasma current. After the first capacitor unit C1 stopping supplying power, the current on the center solenoid L may gradually decrease, and the plasma current can continue to exist during this process. In the embodiment of the present application, the second capacitor unit C2 transmits negative current to the center solenoid L in this process, so that a duration of the plasma current can be increased, and a maintenance time of the breakdown electric field can be prolonged.

In the embodiment of the present application, a switch resistor is provided to increase a current change rate in the circuit and ensure that gas breakdown is more easily realized to obtain the plasma. For example, the current change rate in a circuit can reach 700 A/ms (amperes per millisecond) before a switch resistance is added, and the current change rate can reach 1000 A/ms after the switch resistance is provided. In some implementations, this switch resistor can replace the current-limiting resistor R3 with different resistance values as required.

In the embodiment of the present application, the power supply module set can include a plurality of power supply modules, so that the capacitor unit for supplying power to the center solenoid can be switched among the plurality of power supply modules, a plurality of current pulses can be continuously supplied to the center solenoid, and then multiple times of gas breakdown can be realized in a short time to form the plasma, which is beneficial to prolonging the duration of a nuclear fusion reaction. In some implementations, a capacitor unit with a relatively large capacitance can be used to realize multiple times of power supply to the center solenoid and multiple times of gas breakdown. Exemplarily, the capacitance of the capacitor unit may be 8.4 Farads. A specific value of this capacitance can also be changed based on actual needs, and is not limited herein.

When the capacitor unit in the embodiment of the present application outputs the pulse current, the voltage value can reach 400 volts, and the current value can reach 20 kiloamperes, so that a large current pulse can be realized at a relatively low voltage. The power supply based on this capacitor unit can enable a maintaining time of the plasma to reach 100 milliseconds. Because this voltage value is relatively low, an insulation requirement and an insulation distance of each part of the circuit can be reduced, so that a manufacturing cost may be reduced, and miniaturization of the driving power supply is easier to realize. In the embodiment of the present application, the capacitance, an output voltage and output current of the capacitor unit in each power supply module may be the same, or some power supply modules may use different capacitor units, which is not limited herein.

In summary, the driving power supply provided in the embodiment of the present application includes two power supply module sets which are respectively connected with the two ends of the center solenoid, where the power supply module in each power supply module set includes a capacitor unit, a first power unit and a second power unit which are sequentially connected, and an auxiliary node between these two power units is connected with the center solenoid. A second end of each second power unit in any power supply module set is connected with a second end of one second power unit in the other power supply module set. This driving power supply can be turned on or turned off via each power unit, so that a capacitor unit for transmitting the current to the center solenoid is switched among the capacitor units in different power supply module sets. Switching of the capacitor unit can reverse a direction of the current transmitted on the center solenoid, so that a positive and negative pulse current can be transmitted to the center solenoid alternately, and a relatively high change rate of the current transmitted to the center solenoid is ensured.

In some implementations, the voltage at both ends of the center solenoid L may be controlled by a pulse width modulation (PWM) to control the current change rate on the center solenoid L and, in turn, control a capability to drive the plasma current. At a target phase (hereinafter referred to as a power supply phase of this capacitor unit) in which the capacitor unit of each power supply module transmits the current to the center solenoid, and a turn-on duty ratio of the power unit turned on in this target phase can further be controlled, so as to control the turning on and turning off of the power unit based on the turn-on duty ratio to adjust the current value in the circuit. For example, in a power supply phase of the first capacitor unit C1, the turn-on duty ratios of the power units G12 and G21 can be controlled to adjust the value of the current transmitted to the center solenoid L. In a power supply phase of the second capacitor unit C2, the turn-on duty ratios of the power unit G11 and G22 can be controlled.

In the power supply phase of the capacitor unit of any one of the first power supply module and the second power supply module, the turn-on duty ratio of the first power unit in this power supply module is less than 1, and the turn-on duty ratio of the second power unit in the other power supply module is equal to 1. This turn-on duty ratio can be obtained based on a target voltage corresponding to the center solenoid and an output voltage of this capacitor unit. This target voltage is an operating voltage required for the center solenoid to excite the plasma.

Exemplarily, in the power supply phase of the first capacitor unit C1 in the driving power supply 10, the current on the center solenoid L climbs positively. In this phase, the turn-on duty ratio of the power unit G11 is less than 1, and the power unit G11 is alternately turned on and turned off; and the turn-on duty ratio of the power unit G22 is 1, and the power unit G22 is continuously in a turning-on state. In the power supply phase of the second capacitor unit C2, the current on the center solenoid is transmitted reversely. In this phase, the turn-on duty ratio of the power unit G21 is less than 1, and the power unit G21 is alternately turned on and turned off; and the turn-on duty ratio of the power unit G12 is 1, and the power unit G12 is continuously in a turning-off state.

In some implementations, in the power supply phase of the capacitor unit in any power supply module, a sum of the turn-on duty ratios of the first power unit and the second power unit in this power supply module may be equal to 1, and this first power unit and the second power unit may be turned on alternately. For example, in the power supply phase of the first capacitor unit C1, the power units G11 and G12 may be periodically and alternately turned on. When the power unit G11 is turned on, the power unit G12 is turned off, and the first capacitor unit C1 discharges to the center solenoid L; and when the power unit G12 is turned on, the power unit G11 is turned off, and the current on the center solenoid L freewheels via the power units G22 and G12. For another example, in the power supply phase of the second capacitor unit C2, the power units G21 and G22 may be periodically and alternately turned on. When the power unit G21 is turned on, the power unit G22 is turned off, and the second capacitor unit C2 discharges to the center solenoid L; and when the power unit G22 is turned on, the power unit G21 is turned off, and the current on the center solenoid L freewheels via the power units G12 and G22.

In the embodiment of the present application, in the power supply phase of the capacitor unit in any power supply module, the turn-on duty ratio of the first power unit in this power supply module may be obtained based on the target voltage corresponding to the center solenoid and the output voltage of this capacitor unit. This target voltage may be a voltage required for the center solenoid to excite the plasma. Exemplarily, it is assumed that the current-limiting resistor R3 is not considered. In the power supply phase of the first capacitor unit C1, a target voltage corresponding to the center solenoid L is U1, an output voltage of the first capacitor unit C1 is U0, then the turn-on duty ratio of the power unit G11 may be U0/U1, and the turn-on duty ratio of the power unit G12 may be 1-U0/U1. In the power supply phase of the second capacitor unit C2, a target voltage corresponding to the center solenoid L is -U2, an output voltage of the second capacitor unit C2 is U0, then the turn-on duty ratio of the power unit G21 may be -U0/U2, and the turn-on duty ratio of the power unit G22 may be 1+ U0/U2.

In the embodiment of the present application, the turn-on duty ratio of each power unit is controlled, so that the maintaining duration of the plasma can reach 500 milliseconds, the maintaining duration of the plasma is prolonged, and a fusion reaction effect of the plasma is improved.

In some implementations, after the power supply phase of the capacitor unit in any power supply module, there may be a freewheeling phase of the center solenoid L, and in this freewheeling phase, two power units in this power supply module may be turned off, while two power units in the other power supply module may be turned on alternately. Exemplarily, after the power supply phase of the first capacitor unit C1, the center solenoid L may be in a freewheeling phase for a certain duration, in this phase, the power units G11 and G12 are maintained to be turned off, and the power units G21 and G22 may be periodically and alternately turned on. After the power supply phase of the second capacitor unit C2, the center solenoid L may also be in a freewheeling phase for a certain duration, in this phase, the power units G21 and G22 are maintained to be turned off, and the power units G11 and G12 may be periodically and alternately turned on.

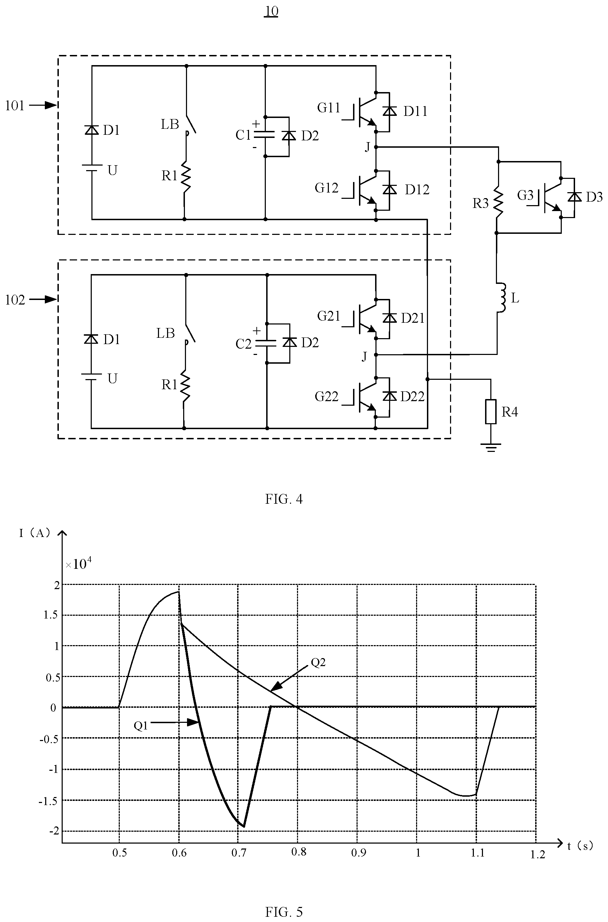

FIG. 5 is a schematic diagram of a current change on a center solenoid provided in an embodiment of the present application. A curve Q1 represents a current change on the center solenoid brought by a natural discharge of the capacitor unit and the center solenoid in a case where the turn-on duty ratio of the power unit is not controlled; and a curve Q2 represents a current change on the center solenoid in a case where the turn-on duty ratio of the power unit is controlled in the embodiment of the present application. It can be seen from a comparison between the curve Q1 and the curve Q2 that, in the embodiment of the present application, the current change rate of the center solenoid in a current decrease phase can be controlled by controlling the turn-on duty ratio. For example, the current change rate can be maintained at a constant rate of decrease, and the duration of the decrease phase can be extended, thus increasing the maintaining duration of the plasma.

The driving power supply 10 is only introduced above only with respect to some necessary components in the driving power supply 10 of the center solenoid, and the driving power supply 10 may further include other additional components on the basis of the aforementioned components. FIG. 4 is a schematic structural diagram of a circuit of further another driving power supply of a center solenoid provided in an embodiment of the present application. A case where the driving power supply 10 includes other additional components is introduced below in combination with FIG. 4. Each power supply module of the driving power supply 10 may further include: two freewheeling diodes, which may also be referred to as a first freewheeling diode and a second freewheeling diode, and these two freewheeling diodes are respectively connected in parallel with the two power units in the power supply module. Specifically, in some embodiments, the first end of the first power unit may be connected with an output end of the first freewheeling diode; the second end of the first power unit is connected with an input end of the first freewheeling diode; and the first end of the second power unit is connected with an output end of the second freewheeling diode, and the second end of the second power unit is connected with an input end of second freewheeling diode. As shown in FIG. 4, the first power unit G11 in the first power supply module set 101 is connected in parallel with the freewheeling diode D11, and the second power unit G12 is connected in parallel with the freewheeling diode D12; and the first power unit G21 in the second power supply module set 102 is connected in parallel with the freewheeling diode D21, and the second power unit G22 is connected in parallel with the freewheeling diode D22.

The above freewheeling diode is configured to play a freewheeling role on the center solenoid L when the capacitor unit stops supplying power to the center solenoid L. In this way, when the current in the circuit changes suddenly, the current on the center solenoid L still maintains to flow in an original direction, and a case that the center solenoid L is damaged due to over high voltage generated at the two ends of the center solenoid L is avoided.

Exemplarily, for the driving power supply 10 shown in FIG. 4, the power unit G11 and G22 may be first controlled to be turned on, and the power unit G12 and G21 may be controlled to be turned off, so that the first capacitor unit C1 supplies power to the center solenoid L, and at this time, the power supply phase of the first capacitor unit C1 begins. After the current transmitted in the center solenoid L reaches a first current value, the power unit G11 and the power unit G22 may be turned off, so that the first capacitor unit C1 stops supplying power to the center solenoid L, and at this time, the power supply phase of the first capacitor unit C1 is ended. Thereafter, the current in the center solenoid L can be freewheeled via the freewheeling diode D21, the second capacitor unit C2, and the freewheeling diode D12, and this phase is also the above freewheeling phase. This first current value may be a current peak value of the desired pulse current. In this freewheeling phase, the power units G21 and G22 can be turned on alternately.

After that, the power units G12 and G21 can be controlled to be turned on, and the power units G11 and G22 can be controlled to be turned off, so that the second capacitor unit C2 supplies power to the center solenoid L, the direction of the current on the center solenoid L is reversed, and at this time, the power supply phase of the second capacitor unit C2 begins. After the current transmitted in the center solenoid L reaches a second current value, the power units G12 and G21 may be turned off, so that the second capacitor unit C2 stops supplying power to the center solenoid L, and at this time, the power supply phase of the second capacitor unit C2 is ended. Thereafter, the current in the center solenoid L can be freewheeled via the freewheeling diode D11, the first capacitor unit C1, and the freewheeling diode D22, and this phase is also the aforementioned freewheeling phase. In some implementations, the second current value may be equal to the first current value. In this freewheeling phase, the power units G11 and G12 can be turned on alternately.

Please continue to refer to FIG. 4, each power supply module in the driving power supply 10 may further include: a direct current power supply U, a first anti-reverse diode D1 and a second anti-reverse diode D2. In each power supply module, the first anti-reverse diode D1 is connected in series with the direct current power supply U, and the second anti-reverse diode D2 is connected in parallel with the capacitor unit. For example, a positive electrode of the direct current power supply U is connected with a positive electrode of the capacitor unit via the first anti-reverse diode D1. A positive electrode of the direct current power supply U is connected with an input end of the first anti-reverse diode D1, an output end of the first anti-reverse diode D1 is connected with the positive electrode of the capacitor unit, the positive electrode of the capacitor unit is further connected with an output end of the second anti-reverse diode D2, and a negative electrode of the capacitor unit is further connected with an input end of the second anti-reverse diode D2. In some implementations, the direct current power supply U in different power supply modules may also be shared.

In each power supply module, the direct current power supply U is configured to charge the capacitor unit, and the capacitor unit transmits the current to the center solenoid L by controlling the turning on and turning off of the power unit after the charging is completed. The first anti-reverse diode D1 can prevent the capacitor unit from reversely charging the direct current power supply U, and can prevent the direct current power supply U from reversely charging the capacitor unit, and if a circuit connection between the direct current power supply U and the capacitor unit is incorrect, the capacitor unit cannot be charged. The second anti-reverse diode D2 is configured to prevent the circuit from reversely charging the capacitor unit.

Please continue to refer to FIG. 4, each power supply module in the driving power supply 10 may further include: a relay LB and a bleeder resistor R1. In each power supply module, the relay LB and the bleeder resistor R1 may be connected in series, and connected in parallel with the capacitor unit. For example, the positive electrode of the capacitor unit is further connected with a first end of the relay LB, a second end of the relay LB is connected with a first end of the bleeder resistor R1, and the negative electrode of the capacitor unit C is further connected with a second end of the bleeder resistor R1. The bleeder resistor R1 may be a wire-wound resistor.

The bleeder resistor R1 may be configured to bleed voltage for the capacitor unit connected in parallel. The relay LB may be in a turning-off state in the process that the capacitor unit supplies power to the load. When the capacitor unit stops supplying power to the load (for example, the voltage on the capacitor unit decreases to 0), there may be some residual electric energy in the capacitor unit, and at this time, the relay LB can be closed, so that the bleeder resistor R1 can bleed the residual voltage in the capacitor unit. The relay LB may also be in the turning-off state in the process that the direct current power supply charges the capacitor unit.

Exemplarily, after turning off the power units G11 and G22, the relay LB in the first power supply module set 101 may be closed, so that the bleeder resistor R1 in the first power supply module set 101 bleeds the residual voltage in the first capacitor unit C1. After turning off the power units G12 and G21, the relay LB in the second power supply module set 102 may be closed, so that the bleeder resistor R1 in the second power supply module set 102 bleeds the residual voltage in the second capacitor unit C2.

If the first capacitor unit C1 and the second capacitor unit C2 supply power to the center solenoid L for a plurality of power supply cycles, the relay LB in the first power supply module set 101 and the second power supply module set 102 may be closed after the plurality of power supply cycles are ended, so as to bleed the residual voltage in the first capacitor unit C1 and the second capacitor unit C2.

Please continue to refer to FIG. 4, the driving power supply 10 may further include a resistor R4, and the resistor R4 is grounded. The second end of the second power unit G2 in each power supply module of the driving power supply 10 is further connected with this resistor R4.

In the embodiment of the present application, the power unit (such as the above first power unit, the second power unit, and the third power unit) in the driving power supply 10 may be a full-power device, and a switching time may be at a level of microseconds. For example, this power unit may include an insulated-gate bipolar transistor (IGBT). A first end of the power unit is a collector, and a second end of the power unit is an emitter. In some implementations, the power unit may also include an integrated gate converter thyristor (IGCT) or a gate turn off thyristor (GTO).

In one embodiment, an operating current of each power unit may reach 20 kiloamperes. Exemplarily, each power unit may be obtained by connecting a plurality of power sub-units in parallel, and each power sub-unit may be one IGBT, IGCT, or GTO. For example, one power unit can be obtained by connecting 10 IGBTs in parallel, and an operating current of each IGBT can reach 2 kiloamperes.

In summary, the driving power supply provided in the embodiment of the present application includes two power supply module sets which are respectively connected with two ends of the center solenoid, where the power supply module in each power supply module set includes the capacitor unit, the first power unit and the second power unit which are sequentially connected, and the auxiliary node between these two power units is connected with the center solenoid. The second end of each second power unit in any power supply module set is connected with the second end of one second power unit in the other power supply module set. This driving power supply can be turned on or turned off via each power unit, so that the capacitor unit for transmitting the current to the center solenoid is switched among the capacitor units in different power supply module sets. The switching of the capacitor unit can reverse the direction of the current transmitted on the center solenoid, so that the positive and negative pulse current can be transmitted to the center solenoid alternately, and the relatively high change rate of the current transmitted to the center solenoid is ensured. In the embodiment of the present application, the above driving power supply 10 is used to drive the center solenoid L. This driving power supply 10 may further be connected with a control system, so that a worker can control the driving power supply 10 via this control system, thereby driving the center solenoid L. An embodiment of the present application further provides a driving system of a center solenoid. A driving power supply 10 may be a main power part in the driving system of the center solenoid, and this driving system further includes a control system 20 based on the driving power supply 10. This control system 20 is introduced below in combination with the drawings.

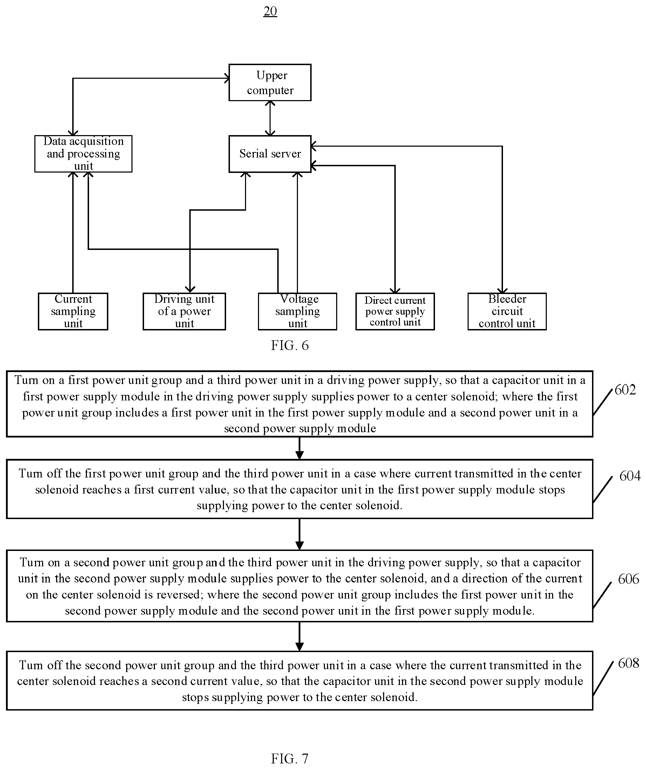

FIG. 6 is a schematic structural diagram of a control system provided in an embodiment of the present application. As shown in FIG. 6, this control system 20 may include an upper computer and a serial server. The upper computer is connected with the serial server, and the serial server is further connected with a unit with other functions. A worker can interact with this upper computer to monitor and control each component of the driving power supply 10 and the control system 20. This upper computer can send a control instruction to the unit with other functions via the serial server, so that this unit with other functions can realize corresponding functions. The serial server can further feed state information of the connected functional unit and information obtained by the functional unit back to the upper computer.

This unit with other functions may include a driving unit of the power unit. The serial server is connected with the driving unit of the power unit, and the driving unit of the power unit is further connected with each power unit in the driving power supply 10. For example, this driving unit can be connected with a gate of each power unit. For example, the upper computer may send a control instruction to the driving unit of the power unit via the serial server. The driving unit of the power unit may control the corresponding power unit in the driving power supply 10 to be turned on or turned off based on a received control instruction, thereby realizing the above operating process of the driving power supply 10.

In some implementations, the worker can set a turn-on moment and a turn-on duration of each power unit via the upper computer, and transmit an instruction carrying the time information to the serial server. After that, the serial server may send a turn-on instruction or a turn-off instruction for the corresponding power unit to the driving unit of the power unit at a corresponding time, so that this driving unit controls the power unit to be turned on or turned off.

For example, the driving unit of the power unit first controls the power units G3, G11 and G22 in the driving power supply shown in FIG. 4 to be turned on based on the received control instruction, and then controls the power units G3, G11 and G22 to be turned off after a certain duration. Then, the power units G3, G12 and G21 are controlled to be turned on, and the power units G3, G12 and G21 are controlled to be turned off after a certain duration.

Please continue to refer to FIG. 6, the control system 20 may further include a direct current power supply control unit. This direct current power supply control unit is connected with the serial server, and is further connected with a direct current power supply in the driving power supply 10. The upper computer may send the control instruction to the direct current power supply control unit via the serial server, and the direct current power supply control unit controls the direct current power supply in the driving power supply 10 based on the received control instruction to charge or turn off the charging of this capacitor unit of the driving power supply 10. The direct current power supply control unit can further feed an output state of the direct current power supply back to the upper computer.

In some implementations, the worker can set a voltage value and a current value which should be output by the direct current power supply via the upper computer. The upper computer can transmit this voltage value and current value to the direct current power supply control unit in advance via the serial server, so that the direct current power supply control unit can directly send the control instruction to the direct current power supply based on this value, so that the direct current power supply can transmit current meeting this voltage value and current value to the capacitor unit.

Please continue to refer to FIG. 6, the control system 20 may further include a bleeder circuit control unit for controlling a bleeder circuit in the driving power supply 10, and this bleeder circuit includes a relay LB and a bleeder resistor R1 in the driving power supply 10. The bleeder circuit control unit may be connected with the serial server and connected to the relay LB in the driving power supply 10.

The upper computer may send the control instruction to the bleeder circuit control unit via the serial server. The bleeder circuit control unit controls the relay to be turned on or turned off based on the received control instruction. The bleeder circuit control unit can further feed an on-off state of the relay back to the serial server, and then the serial server can feed the on-off state back to the upper computer, so as to realize that the upper computer monitors the state of the devices in the driving power supply 10. Please continue to refer to FIG. 6, the control system 20 may further include a monitoring unit and a data acquisition and processing unit, where the monitoring unit is connected with the data acquisition and processing unit, and the data acquisition and processing unit is further connected with the upper computer. The monitoring unit may monitor voltage data and/or current data in a circuit of the driving power supply 10 and transmit the acquired data to the data acquisition and processing unit. The data acquisition and processing unit may process the received data and transmit the processed data to the upper computer, so that the upper computer can monitor the state of the driving power supply 10. The upper computer may determine a turn-on duty ratio of each power unit in the driving power supply 10 based on the data transmitted by the data acquisition and processing unit, then may generate a control instruction for each power unit based on this turn-on duty ratio, and send this control instruction to the driving unit of the power unit via the serial server. This driving unit can control the turning on and turning off of each power unit based on the turn-on duty ratio in response to this control instruction.

The monitoring unit may include a current sampling unit and/or a voltage sampling unit, and FIG. 6 illustrates that the monitoring unit includes a current sampling unit and a voltage sampling unit. This current sampling unit is configured to collect current data in the circuit of the driving power supply 10, and this voltage sampling unit is configured to collect voltage data in the circuit of the driving power supply 10. The data acquisition and processing unit can acquire and record data such as total output current of the driving power supply 10, current of each bridge arm branch, and a voltage of the capacitor unit. This bridge arm branch refers to a branch where the power unit in the power supply module is located. The data acquisition and processing unit can further judge whether the current in the circuit reaches the required current value based on the current data, and judge whether the voltage in the circuit reaches the required voltage value based on the voltage data.

The current sampling unit can be configured to detect the current output by each capacitor unit in the driving power supply 10, the current transmitted in the center solenoid L, and the current at each power unit. The voltage sampling unit can be configured to detect the voltages at two ends of each capacitor unit in the driving power supply 10 and the voltages at two ends of the direct current power supply.

In the embodiment of the present application, a convenient and efficient monitoring and remote operation of the driving power supply 10 can be realized via this control system 20, and thus a remote driving of the center solenoid L can be realized. For example, the worker can use this control system 20 to manually or automatically charge and discharge the capacitor unit in the driving power supply 10, and monitor the state of the voltage and current in the driving power supply 10 in real time.

FIG. 7 is a flow chart of a driving method of a center solenoid provided in an embodiment of the present application. This method can be applied to the above driving system of the center solenoid, and is specifically configured to control the driving power supply 10 in this driving system. For example, this driving power supply can be controlled by a control system in this driving system, so as to drive the center solenoid. This method may be cross-referenced to the above introduction of the driving power supply 10 of FIG. 1 to FIG. 4. The method provided in FIG. 7 can be executed by a driving unit of a power unit in the control system 20, for example, the method is executed by this driving unit based on a control instruction sent by an upper computer via a serial server. As shown in FIG. 7, this method may include:
Step 602. Turning on a first power unit group and a third power unit in the driving power supply, so that a capacitor unit in a first power supply module in the driving power supply supplies power to the center solenoid; where the first power unit group includes a first power unit in the first power supply module and a second power unit in a second power supply module.

In the embodiment of the present application, the first power unit group may include one first power unit and one second power unit respectively belonging to two power supply module sets in the driving power supply, and this second power unit is connected with a second power unit in the power supply module to which the first power unit belongs. Here takes that the first power unit group includes the first power unit in the first power supply module and the second power unit in the second power supply module as an example. For the first power supply module and the second power supply module, reference may be made to the foregoing introduction. In the process of turning on the first power unit group in the driving power supply, other power units belonging to the same power supply module as the power unit in the first power unit group are in a turning-off state. In the embodiment of the present application, turning on or turning off a certain power unit group refers to turning on or turning off each power unit in this power unit group.

For example, please refer to FIG. 1, the first power supply module may be one first power supply module in the first power supply module set 101. The first power unit group may include a first power unit G11 in the first power supply module set 101 and a second power unit G22 in the second power supply module set 102. The power units G11 and G22 are turned on, and the power units G12 and G21 are in the turning-off state, so that a first capacitor unit C1 supplies power to the center solenoid L. In one embodiment, the first power unit group may also include a second power unit G12 in the first power supply module set 101 and a first power unit G21 in the second power supply module set.

Step 604. Turning off the first power unit group and the third power unit in a case where current transmitted in the center solenoid reaches a first current value, so that the capacitor unit in the first power supply module stops supplying power to the center solenoid.

In an implementation, the upper computer in the control system 20 may set a turning-on duration of the power unit in the first power unit group in advance, and when this turning-on duration is reached, it is considered that the current transmitted in the center solenoid reaches the first current value. The driving unit of the power unit can start timing after triggering the turning on of this power unit, when the timing reaches this turning-on duration, this driving unit may turn off the power unit in the first power unit group.

In another implementation, a current sampling unit in the control system 20 detects the current transmitted in the center solenoid, and feeds this information back to the upper computer when a data acquisition and processing unit determines that this current reaches the first current value. After receiving this feedback information, the upper computer may send a control instruction to a driving unit of the power unit via the serial server, so that this driving unit turns off the power unit in the first power unit group.

Step 606. Turning on a second power unit group and the third power unit in the driving power supply, so that a capacitor unit in the second power supply module supplies power to the center solenoid, and a direction of the current on the center solenoid is reversed; where the second power unit group includes the first power unit in the second power supply module and the second power unit in the first power supply module.

In the embodiment of the present application, the second power unit group may include the other first power unit and the other second power unit respectively belonging to two power supply module sets, where the second power unit in the power supply module to which the other first power unit belongs to is connected with the other second power unit. In one embodiment, the first power unit in the second power unit group and the second power unit in the first power unit group may belong to the same power supply module, and the second power unit in the second power unit group and the first power unit in the first power unit group may belong to the same power supply module. Here takes that the second power unit group includes the first power unit in the second power supply module and the second power unit in the first power supply module as an example. For the first power supply module and the second power supply module, reference may be made to the foregoing introduction. In a process of turning on the second power unit group, other power units belonging to the same power supply module as the power unit in the second power unit group are in a turning-off state.

For example, please refer to FIG. 1, the second power supply module may be one power supply module in the second power supply module set 102. The second power unit group may include a second power unit G12 in the first power supply module set 101 and a first power unit G21 in the second power supply module set 102. The units G12 and G21 are turned on, and the power of the power units G11 and G22 are in the tuning-off state, so that the second capacitor unit C2 may supply power to the center solenoid L.

After the second power unit group in the driving power supply is turned on, a turn-on duty ratio of the power unit in the second power unit group can be adjusted to adjust the current transmitted to the center solenoid by the capacitor unit in the second power supply module. For example, the power unit in the second power unit group can be turned on intermittently to adjust the turn-on duty ratio of the power unit in the second power unit group.

Step 608. Turning off the second power unit group and the third power unit in a case where the current transmitted in the center solenoid reaches a second current value, so that the capacitor unit in the second power supply module stops supplying power to the center solenoid.

Step 608 is similar to Step 604, and is not repeated here in the embodiment of the present application.

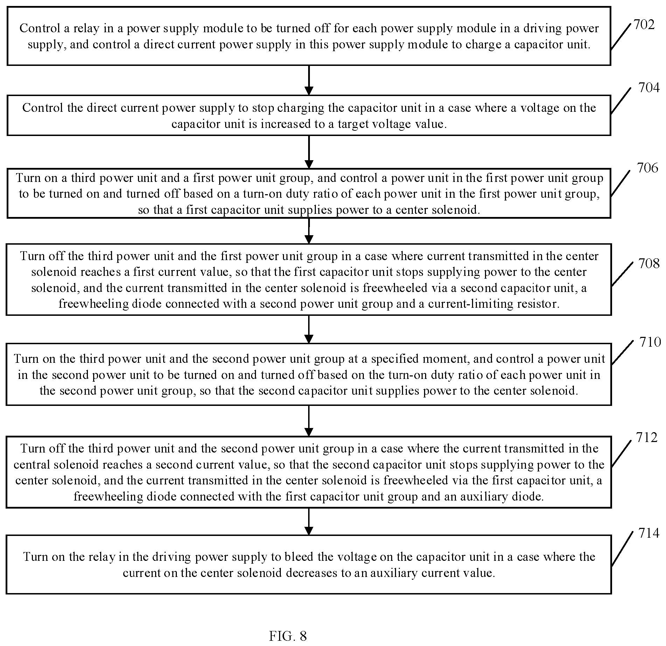

To sum up, in the driving method of the center solenoid provided by the embodiment of the present application, the first power unit group and the second power unit group may be turned on alternately, so that the capacitor unit in the first power supply module and the capacitor unit in the second power supply module alternately supply power to the center solenoid, and the direction of the current on the center solenoid is reversed after the capacitor unit supplying power is switched. Positive and negative pulse current can be transmitted to the center solenoid alternately in this way, and a relatively high change rate of the current transmitted to the center solenoid is ensured. In the embodiment of the present application, the driving method of the center solenoid is further introduced by taking the driving power supply 10 shown in FIG. 4 as an example. This method may be cross-referenced to the above introduction of the driving power supply 10 of FIG. 1 to FIG. 4 and the introduction of FIG. 7. FIG. 8 is a flow chart of another driving method of a center solenoid provided in an embodiment of the present application. As shown in FIG. 8, this method may include:
Step 702. Controlling the relay in this power supply module to be turned off for each power supply module in the driving power supply, and controlling the direct current power supply in this power supply module to charge the capacitor unit.

In the embodiment of the present application, a bleeder circuit control unit in the control system 20 may control the relay to be turned off, and the direct current power supply control unit may control the direct current power supply to charge the capacitor unit.

Step 704. Controlling the direct current power supply to stop charging the capacitor unit in a case where the voltage on the capacitor unit is increased to the target voltage value.

Exemplarily, this target voltage value may be a maximum voltage value needed to be stored by the capacitor unit, and this target voltage value may be preset. The target voltage values corresponding to different capacitor units in the driving power supply may be the same or different.

In the embodiment of the present application, whether the voltage on the capacitor unit reaches the target voltage value can be determined via the voltage sampling unit, and then the direct current power supply control unit controls the direct current power supply to stop charging the capacitor unit when the voltage reaches this target voltage value.

Step 706. Turning on the third power unit and the first power unit group, and controlling the power unit in the first power unit group to be turned on and turned off based on the turn-on duty ratio of each power unit in the first power unit group, so that the first capacitor unit supplies power to the center solenoid.

In the embodiment of the present application, the driving unit of the power unit in the control system 20 can control the third power unit G3 and the power unit in the first power unit group to be turned on.

As shown in FIG. 4, this first power unit group may include the power units G11 and G22. Moreover, the power unit in the second power unit group can be maintained in a turning-off state, and this second power unit group can include the power units G12 and G21. In this way, the first capacitor unit C1 may supply power to the center solenoid L. The current output from the positive electrode of the first capacitor unit C1 may be transmitted to the center solenoid L via the power unit G11 and the third power unit G3. The current output from the center solenoid L flows to the negative electrode of the first capacitor unit C1 via the power unit G22.

In some implementations, the turn-on duty ratio of the first power unit (for example, G11) in the first power unit group is less than 1, and the turn-on duty ratio of the second power unit (for example, G22) in the first power unit group is equal to 1. In the phase that the first capacitor unit C1 supplies power to the center solenoid L, the first power unit G11 and the second power unit G12 in the first power supply module can be controlled to be alternately turned on based on the turn-on duty ratio of the first power unit G11 in the first power supply module, the first power unit G21 in the second power supply module can be controlled to be continuously turned off, and the second power unit G22 in the second power supply module is controlled to be continuously turned on. The sum of the turn-on duty ratio of the power unit G11 and the turn-on duty ratio of the power unit G12 may be equal to 1.

Step 708. Turning off the third power unit and the first power unit group in a case where the current transmitted in the center solenoid reaches the first current value, so that the first capacitor unit stops supplying power to the center solenoid, and the current transmitted in the center solenoid is freewheeled via the second capacitor unit, a freewheeling diode connected with the second power unit group and a current-limiting resistor.

In the embodiment of the present application, the current sampling unit in the control system 20 can determine whether the current transmitted in the center solenoid reaches the first current value. When the first current value is reached, the driving unit of the power unit in the control system 20 can control the third power unit G3 and the power units G11 and G22 in the first power unit group to be turned off.

After the third power unit G3 and the power units G11 and G22 are turned off, the center solenoid L can still output the current, and at this time, a transmission direction of the current is still an original direction. Therefore, the current output by the center solenoid L may be transmitted via the freewheeling diode D21 connected in parallel with the power unit G21, the second capacitor unit C2, the freewheeling diode D12 connected in parallel with the power unit G12, and the current-limiting resistor R3 in sequence, so as to realize freewheeling. In this freewheeling phase, the first power unit G21 and the second power unit G22 in the second power supply module can be turned on alternately.

Step 710. Turning on the third power unit and the second power unit group at a specified moment, and controlling the power unit in the second power unit group to be turned on and turned off based on the turn-on duty ratio of each power unit in the second power unit group, so that the second capacitor unit supplies power to the center solenoid.

In the embodiment of the present application, the third power unit G3 and the power units G12 and G21 in the second power unit group can be controlled to be turned on via the driving unit of the power unit in the control system 20.

In the freewheeling process, the current can continue to be transmitted for a certain duration. In the embodiment of the present application, this specified moment can be determined according to a breakdown condition of gas in a nuclear fusion reaction chamber caused by the current in the freewheeling process and a required remaining time of the generated plasma. This specified moment may be a moment at which the current in the freewheeling process is about to decrease to zero. For example, if the freewheeling can be maintained for 10 milliseconds after the first capacitor unit C1 stops supplying power, the third power unit and the second power unit group may be turned on after the third power unit and the first power unit group are turned off for 10 milliseconds, so that the second capacitor unit C2 starts supplying power.

In some embodiments, the turn-on duty ratio of the first power unit (for example, G21) in the second power unit group is less than 1, and the turn-on duty ratio of the second power unit (for example, G12) is equal to 1. In the phase that the second capacitor unit C2 supplies power to the center solenoid L, the first power unit G21 and the second power unit G22 in the second power supply module can be controlled to be alternately turned on based on the turn-on duty ratio of the first power unit G21 in the second power supply module, the first power unit G11 in the first power supply module can be controlled to be continuously turned off, and the second power unit G12 can be controlled to be continuously turned on. The sum of the turn-on duty ratio of the power unit G21 and the turn-on duty ratio of the power unit G22 may be equal to 1.

Step 712. Turning off the third power unit and the second power unit group in a case where the current transmitted in the center solenoid reaches the second current value, so that the second capacitor unit stops supplying power to the center solenoid, and the current transmitted in the center solenoid is freewheeled via the first capacitor unit, a freewheeling diode connected with the first power unit group and the auxiliary diode. In the embodiment of the present application, the current sampling unit in the control system 20 can determine whether the current transmitted in the center solenoid reaches a second current value. When the second current value is reached, the third power unit G3 and the power units G12 and G21 in the second power unit group may be controlled to be turned off via the driving unit of the power unit in the control system 20.

After the third power unit G3 and the power units G12 and G21 are turned off, the center solenoid L can still output the current, and at this time, the transmission direction of the current is still the original direction. Therefore, the current output by the center solenoid L may be transmitted via the auxiliary diode D3 connected in parallel with the third power unit G3, the freewheeling diode D11 connected in parallel with the power unit G11, the first capacitor unit C1 and the freewheeling diode D22 connected in parallel with the power unit G22 so as to realize freewheeling. This freewheeling phase may continue until the current on the center solenoid L decreases to 0 amps. In this freewheeling phase, the first power unit G11 and the second power unit G12 in the first power supply module can be turned on alternately. In some implementations, the third power unit G3 may not be turned on in Step 710, and accordingly, the third power unit G3 may not be turned off in Step 712. Since the direction of the current is reversed during the power supply process of the second capacitor unit C2, the current transmitted by the second capacitor unit C2 is normally transmitted via the auxiliary diode D3 even if the third power unit G3 is not turned on. The above Step 706 to Step 712 are control processes of the driving power supply 10 in one power supply cycle of the center solenoid L. Step 706 to Step 712 may be executed repeatedly after Step 712 to repeatedly supply power to the center solenoid L multiple times. After at least one power supply cycle is ended, Step 714 may be executed.

Step 714. Turning on the relay in the driving power supply to bleed the voltage on the capacitor unit in a case where the current on the center solenoid decreases to an auxiliary current value.

This auxiliary current value may be 0 amps. Whether the current on the center solenoid decreases to the auxiliary current value may be detected by a current sampling unit in the control system 20.

In the embodiment of the present application, the relay in one or more power supply modules in the driving power supply can be turned on via the bleeder circuit control unit in the control system 20 to bleed the voltage on the capacitor unit in the corresponding power supply module. Exemplarily, a relay in the first power supply module may be turned on to bleed the voltage on the first capacitor unit C1, and a relay in the second power supply module may be turned on to bleed the voltage on the second capacitor unit C2.

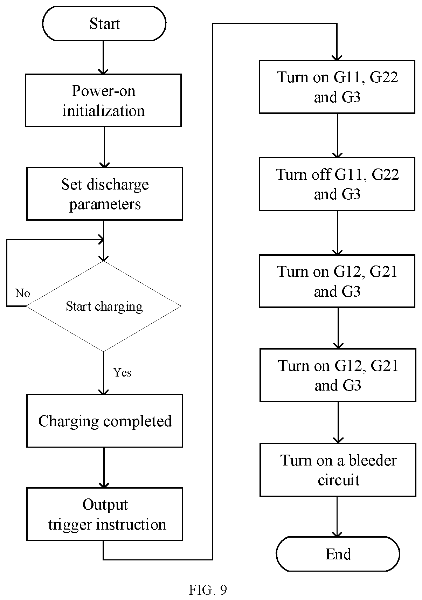

FIG. 9 is a simple working flow chart of a driving system of a center solenoid provided in an embodiment of the present application, which takes that this driving system includes the driving power supply 10 shown in FIG. 4 as an example. As shown in FIG. 9, after this driving system is powered on, each device in this driving system may be initialized, and each device includes the above upper computer, the serial server, the data acquisition and processing unit, the current sampling unit, the driving unit of the power unit, the voltage sampling unit, the direct current power supply control unit and the bleeder circuit control unit.

After that, a discharge parameter required for supplying power to the center solenoid can be set in the upper computer. For example, this discharge parameter may include a trigger turn-on moment of each power unit in the driving power supply and a duration of maintaining the turning-on state, and may further include an output voltage value and a current value of a direct current power supply. Then, a charging instruction may be output to the direct current power supply via the direct current power supply control unit to charge a first capacitor unit C1 and a second capacitor unit C2 based on a set target voltage value. When the voltage values of the first capacitor unit C1 and the second capacitor unit C2 match the target voltage value, the charging of the capacitor units is stopped.

Then, the driving unit of the power unit outputs a trigger instruction to each power unit, so that each power unit is turned on and turned off according to the set time. For example, the power units G11, G22 and G3 are first triggered to be turned on, and then the power units G11, G22 and G3 are triggered to be turned off at a specified time; and then the power units G12, G21 and G3 are triggered to be turned on, and then the power units G12, G21 and G3 are triggered to be turned off at a specified time. After supplying power to the center solenoid L for at least one power supply cycle in this way, the bleeder circuit in the driving power supply 10 can be turned on via the bleeder circuit control unit, and the residual voltage of the first capacitor unit C1 and the second capacitor unit C2 can be bled.

To sum up, in the driving method of the center solenoid provided by the embodiment of the present application, the first power unit group and the second power unit group may be turned on alternately, so that the capacitor unit in the first power supply module and the capacitor unit in the second power supply module alternately supply power to the center solenoid, and the direction of the current on the center solenoid is reversed after the capacitor unit supplying power is switched. The positive and negative pulse current can be transmitted to the center solenoid alternately in this way, and a relatively high change rate of the current transmitted to the center solenoid is ensured.

An embodiment of the present application further provides a fusion reaction system, and this fusion reaction system may include: a nuclear fusion reaction apparatus and the above driving system of the center solenoid. A driving power supply in this driving system may be connected with a center solenoid in the nuclear fusion reaction apparatus and is configured to transmit pulse current to the center solenoid. The center solenoid in this nuclear fusion reaction apparatus is configured to generate a magnetic field based on the pulse current and generate an initial plasma ring by using the magnetic field, and a plasma in the initial plasma ring is configured to be heated to a fusion reaction temperature to generate a fusion reaction.

Because a change rate of the pulse current transmitted by this driving power supply to the center solenoid is relatively high, the working requirement of the center solenoid can be better met, and the center solenoid is ensured to generate a relatively stable magnetic field and then generate a plasma current with better stability, so that the stability of a nuclear fusion reaction is improved. In addition, the driving power supply can be flexibly and efficiently controlled by a control system in this driving system, so that the driving process of the center solenoid can be simplified, and the nuclear fusion reaction process of the nuclear fusion reaction apparatus is correspondingly simplified.

The above describes specific embodiments of the present application. Other embodiments are within the scope of the appended claims. In some cases, the acts or steps recited in the claims may be executed in a different order than those in the embodiments and still achieve desirable results. In addition, the processes depicted in the drawings do not necessarily require the particular order shown or the sequential order to achieve desirable results. Multitasking and parallel processing are also ok or possible or may be advantageous in some implementations.

Those skilled in the art should also understand that the embodiments described in the specification are all preferred embodiments, and the acts and modules involved are not necessarily required for the present application. In the above embodiments, the description of each embodiment has its own emphasis, and for a part not described in detail in a certain embodiment, reference may be made to the relevant description of other embodiments.

The preferred embodiments of the present application disclosed above are only intended to assist in elucidating the present application. The optional embodiments do not provide a detailed description of all the details, nor does it limit the scope of the present application to the specific implementations described. Obviously, many modifications and variations are possible in light of the contents of the present application. These embodiments are chosen and described in detail in the present application in order to better explain the principles of the present application and the practical application, so that those skilled in the art may better understand and use the present application.

## Claims

1. A driving power supply of a center solenoid, **characterized by** comprising:
two power supply module sets; wherein each power supply module set comprises at least one power supply module; each power supply module comprises a capacitor unit, a first power unit and a second power unit; a positive electrode of the capacitor unit is connected with a first end of the first power unit, a second end of the first power unit and a first end of the second power unit are connected with an auxiliary node, and a second end of the second power unit is connected with a negative electrode of the capacitor unit; and a second end of a second power unit in any power supply module of any power supply module set is connected with a second end of a second power unit in a power supply module of the other power supply module set;
a current-limiting resistor;
a third power unit; and
an auxiliary diode; wherein in the two power supply module sets, an auxiliary node in one power supply module set is connected with a first end of the current-limiting resistor, a first end of the third power unit and an output end of the auxiliary diode; a second end of the current-limiting resistor, a second end of the third power unit and an input end of the auxiliary diode are connected with one end of the center solenoid, and an auxiliary node in the other power supply module set is connected with the other end of the center solenoid; and
the first power unit, the second power unit and the third power unit are controlled to be turned on or turned off, so that a capacitor unit for transmitting current to the center solenoid is switched between a capacitor unit in a first power supply module and a capacitor unit in a second power supply module; wherein the first power supply module and the second power supply module belong to different power supply module sets, respectively.

2. The driving power supply of claim 1, **characterized in that** each power supply module set comprises a plurality of power supply modules; and second ends of the second power units in the two power supply module sets are connected.

3. The driving power supply of claim 1, **characterized in that** each power supply module set comprises a plurality of power supply modules; and in the two power supply module sets, a second end of each second power unit in one power supply module set is connected with a second end of each second power unit in the other power supply module set in a one-to-one correspondence manner.

4. The driving power supply of claim 1, **characterized in that** a second end of a second power unit in the first power supply module is connected with a second end of a second power unit in the second power supply module.

5. The driving power supply of claim 1, **characterized in that** in a target phase in which current is transmitted to the center solenoid by the capacitor unit of the first power supply module, a first power unit in the first power supply module is controlled to be turned on and a second power unit in the first power supply module is controlled to be turned off, and a first power unit in the second power supply module is controlled to be turned off and a second power unit in the second power supply module is controlled to be turned on; and
in the target phase, a turn-on duty ratio of the first power unit in the first power supply module is less than 1, and a turn-on duty ratio of the second power unit in the second power supply module is equal to 1; wherein the turn-on duty ratio is obtained base on a target voltage corresponding to the center solenoid and an output voltage of the capacitor unit in the first power supply module.

6. The driving power supply of claim 5, **characterized in that** in the target phase, the first power unit and the second power unit in the first power supply module are controlled to be turned on alternately, the first power unit in the second power supply module is controlled to be turned off continuously and the second power unit is controlled to be turned on continuously.

7. The driving power supply of claim 5 or 6, **characterized in that** after the target phase, the first power unit and the second power unit in the first power supply module are controlled to be turned off, and the first power unit and the second power unit in the second power supply module are controlled to be turned on alternately.

8. The driving power supply of any one of claims 1 to 6, **characterized in that** each power supply module further comprises: a first freewheeling diode and a second freewheeling diode; wherein the first end of the first power unit is connected with an output end of the first freewheeling diode; the second end of the first power unit is connected with an input end of the first freewheeling diode; the first end of the second power unit is connected with an output end of the second freewheeling diode; and the second end of the second power unit is connected with an input end of the second freewheeling diode.

9. The driving power supply of any one of claims 1 to 6, **characterized in that** each power supply module further comprises: a direct current power supply, a first anti-reverse diode and a second anti-reverse diode; wherein in each power supply module, a positive electrode of the direct current power supply is connected with an input end of the first anti-reverse diode, an output end of the first anti-reverse diode is connected with a positive electrode of the capacitor unit, the positive electrode of the capacitor unit is further connected with an output end of the second anti-reverse diode, and a negative electrode of the capacitor unit is connected with an input end of the second anti-reverse diode.

10. The driving power supply of any one of claims 1 to 6, **characterized in that** each power supply module further comprises: a relay and a bleeder resistor; wherein in each power supply module, a positive electrode of the capacitor unit is connected with a first end of the relay, a second end of the relay is connected with a first end of the bleeder resistor, and a negative electrode of the capacitor unit is connected with a second end of the bleeder resistor

11. The driving power supply of any one of claims 1 to 6, **characterized in that** each power unit in the driving power supply comprises: an insulated-gate bipolar transistor (IGBT); wherein a first end of the power unit is a collector, and a second end of the power unit is an emitter.

12. A driving method of a center solenoid, applied to the driving power supply according to and one of claims 1 to 11, and **characterized by** comprising:
turning on a first power unit group and a third power unit in the driving power supply, so that a capacitor unit in a first power supply module in the driving power supply supplies power to the center solenoid; wherein the first power unit group comprises a first power unit in the first power supply module and a second power unit in a second power supply module;
turning off the first power unit group and the third power unit in a case where current transmitted in the center solenoid reaches a first current value, so that the capacitor unit in the first power supply module stops supplying power to the center solenoid;
turning on a second power unit group and the third power unit in the driving power supply, so that a capacitor unit in the second power supply module supplies power to the center solenoid, and a direction of the current on the center solenoid is reversed; wherein the second power unit group comprises a first power unit in the second power supply module and a second power unit in the first power supply module; and
turning off the second power unit group and the third power unit in a case where the current transmitted in the center solenoid reaches a second current value, so that the capacitor unit in the second power supply module stops supplying power to the center solenoid.

13. The method of claim 12, **characterized in that** the turning on a first power unit group and a third power unit in the driving power supply, so that a capacitor unit in a first power supply module in the driving power supply supplies power to the center solenoid comprises:
turning on the first power unit group and the third power unit in the driving power supply, and controlling the turning on and turning off of the power units in the first power unit group based on a turn-on duty ratio of each power unit in the first power unit group, so that the capacitor unit in the first power supply module in the driving power supply supplies power to the center solenoid;
wherein the turn-on duty ratio of the first power unit in the first power unit group is less than 1, and the turn-on duty ratio of the second power unit is equal to 1; and
the turning on a second power unit group and the third power unit in the driving power supply, so that a capacitor unit in the second power supply module in the driving power supply supplies power to the center solenoid comprises:
turning on the second power unit group and the third power unit in the driving power supply, and controlling the turning on and turning off of the power units in the second power unit group based on a turn-on duty ratio of each power unit in the second power unit group, so that the capacitor unit in the second power supply module in the driving power supply supplies power to the center solenoid; wherein the turn-on duty ratio of the first power unit in the second power unit group is less than 1, and the turn-on duty ratio of the second power unit is equal to 1.

14. The method of claim 13, **characterized in that** the controlling the turning on and turning off of the power units in the first power unit group based on a turn-on duty ratio of each power unit in the first power unit group comprises:
controlling the first power unit and the second power unit in the first power supply module to be turned on alternately based on the turn-on duty ratio of the first power unit in the first power supply module, and controlling the first power unit in the second power supply module to be turned off continuously and the second power unit to be turned on continuously; and
the controlling the turning on and turning off of the power units in the second power unit group based on a turn-on duty ratio of each power unit in the second power unit group comprises:
controlling the first power unit and the second power unit in the second power supply module to be turned on alternately based on the turn-on duty ratio of the first power unit in the second power supply module, and controlling the first power unit in the first power supply module to be turned off continuously and the second power unit to be turned on continuously.

15. The method of any one of claims 12 to 14, **characterized by** further comprising:
controlling the first power unit and the second power unit in the second power supply module to be turned on alternately after turning off the first power unit group and the third power unit so that the capacitor unit in the first power supply module stops supplying power to the center solenoid; and
controlling the first power unit and the second power unit in the first power supply module to be turned on alternately after turning off the second power unit group and the third power unit so that the capacitor unit in the second power supply module stops supplying power to the center solenoid.

16. The method of any one of claims 12 to 14, **characterized in that** the turning on a first power unit group and a third power unit in the driving power supply comprises: turning on the third power unit in the driving power supply first, and then turning on the first power unit group in the driving power supply; and
the turning on a second power unit group and the third power unit in the driving power supply comprises: turning on the third power unit first, and then turning on the second power unit group in the driving power supply.

17. The method of any one of claims 12 to 14, **characterized in that** each power supply module in the driving power supply further comprises: a direct current power supply connected in parallel with the capacitor unit, two freewheeling diodes connected in parallel with the first power unit and the second power unit, respectively, and a relay and a bleeder resistor connected in parallel with the capacitor unit after being connected in series; wherein
before the turning on a first power unit group in the driving power supply, the method further comprises:
disconnecting, for each power supply module, the relay and controlling the direct current power supply in the power supply module to charge the capacitor unit to a target voltage value;
turning on a relay in the first power supply module to bleed a voltage on the capacitor unit in the first power supply module after turning off the first power unit group and the third power unit;
wherein the current transmitted in the center solenoid is freewheeled via the capacitor unit in the second power supply module, the freewheeling diode connected with the second power unit group, and a current-limiting resistor; and
turning on a relay in the second power supply module to bleed a voltage on the capacitor unit in the second power supply module after turning off the second power unit group and the third power unit; wherein the current transmitted in the center solenoid is freewheeled via an auxiliary diode, the capacitor unit in the first power supply module and the freewheeling diode connected with the first power unit group.

18. A driving system of a center solenoid, **characterized by** comprising: an upper computer, a serial server, a driving unit of a power unit and the driving power supply according to any one of claims 1 to 11; wherein
the upper computer is configured to send a control instruction to the driving unit of the power unit via the serial server; and
the driving unit of the power unit is configured to control the power unit in the driving power supply to be turned on or turned off based on the received control instruction.

19. The driving system of claim 18, **characterized in that** the driving power supply further comprises a direct current power supply connected with a capacitor unit in the driving power supply; the driving system further comprises: a direct current power supply control unit;
the upper computer is further configured to send a control instruction to the direct current power supply control unit via the serial server; and
the direct current power supply control unit is configured to: control, based on the received control instruction, the direct current power supply in the driving power supply to charge the capacitor unit or cut off a charging of the capacitor unit;
and/or,
each power supply module in the driving power supply further comprises a relay and a bleeder resistor, and the driving system further comprises a bleeder circuit control unit;
the upper computer is further configured to send a control instruction to the bleeder circuit control unit via the serial server; and
the bleeder circuit control unit is configured to control the relay to be turned on or turned off based on the received control instruction and feed an on-off state of the relay back to the serial server.

20. The driving system of claim 18, **characterized by** further comprising: a monitoring unit and a data acquisition and processing unit; wherein
the monitoring unit is configured to monitor voltage data and/or current data in a circuit of the driving power supply and transmit the monitored data to the data acquisition and processing unit; the data acquisition and processing unit is configured to process the received data and transmit the processed data to the upper computer; and
the upper computer is further configured to determine a turn-on duty ratio of each power unit in the driving power supply based on the processed data, and generate the control instruction based on the turn-on duty ratio.

21. A fusion reaction system, **characterized by** comprising: a nuclear fusion reaction apparatus and the driving system according to any one of claims 18 to 20; wherein
a driving power supply in the driving system is connected with a center solenoid in the nuclear fusion reaction apparatus and is configured to transmit pulse current to the center solenoid; and
the center solenoid is configured to generate a magnetic field based on the pulse current and generate an initial plasma ring by using the magnetic field, and a plasma in the initial plasma ring is configured to be heated to a fusion reaction temperature, so as to generate a fusion reaction.
